# EUROPÄISCHE PATENTSCHRIFT

(11) **EP 1 390 982 B1**
(45) Veröffentlichungstag und Bekanntmachung des Hinweises auf die Patenterteilung: **11.05.2011**
(21) Anmeldenummer: 02740648.7
(22) Anmeldetag: 24.05.2002
(51) Int. Cl.: H01L 29/36

(54) **HALBLEITERSTRUKTUR UND VERFAHREN ZUR VERBESSERUNG DER ESD- UND DER UEBERLAST-FESTIGKEIT DERSELBEN**
SEMICONDUCTOR STRUCTURE AND METHOD FOR IMPROVING ITS ABILITY TO WITHSTAND ELECTROSTATIC DISCHARGE (ESD) AND OVERLOADS
STRUCTURE SEMI-CONDUCTRICE ET PROCEDE POUR AMELIORER SA RESISTANCE A LA DECHARGE ELECTROSTATIQUE ET AUX SURCHARGES

(30) Priorität: 31.05.2001 DE 10126627
(43) Veröffentlichungstag der Anmeldung: 25.02.2004
(73) Patentinhaber: Infineon Technologies AG, 85579 Neubiberg (DE)
(72) Erfinder: DIEFENBECK, Klaus, 81247 München (DE); HERZUM, Christian, 82343 Pöcking (DE); HUBER, Jakob, Beyharting 83104 (DE); MUELLER, Karlheinz, Velden 84149 (DE)
(74) Vertreter: Zimmermann, Tankred Klaus
(86) Internationale Anmeldenummer: PCT/EP2002/005732
(87) Internationale Veröffentlichungsnummer: WO 2002/097897

(56) Entgegenhaltungen:
- US-B1- 6 232 822
- PATENT ABSTRACTS OF JAPAN vol. 2000, no. 05, 14. September 2000 (2000-09-14) -& JP 2000 058870 A (NIPPON INTER ELECTRONICS CORP), 25. Februar 2000 (2000-02-25)

## Beschreibung

Die vorliegende Erfindung bezieht sich auf eine Halbleiterstruktur, auf ein Verfahren zur Verbesserung der ESD-Festigkeit desselben und auf ein Verfahren zur Verbesserung der Überlast-Festigkeit derselben.

Die vorliegende Erfindung bezieht sich insbesondere auf ESDgefährdete Halbleiterbauelemente (ESD = Electro Static Discharge). Solche ESD-gefährdeten Bauelemente sind insbesondere Bauelemente, deren parasitären Kapazitäten bedeutend kleiner sind als die Quellkapazitäten in einem ESD-Testverfahren. Beim sogenannten Human Body Model (HBM) liegen die Kapazitäten im Bereich von etwa 100 pF. Unter die relevanten Bauelemente fallen Hochfrequenzdioden und Hochfrequenzbipolartransistoren. Bei Bipolartransistoren stellt in Abhängigkeit von der Technologie entweder die Emitter-Basis- oder die Basis-Kollektor-Strecke die Schwachstelle bezüglich einer ESD-Belastung dar.

Die vorliegende Erfindung bezieht sich ferner insbesondere auf Halbleiterbauelemente, die durch auftretende Überspannungen von einer Zerstörung bedroht sind, wobei solche Überspannungs-gefährdete Bauelemente, wie auch im ESD-Fall, z.B. Hochfrequenzdioden und Hochfrequenzbipolartransistoren umfassen. Bei Spannungs- bzw. Stromüberlast - verursacht z.B. durch Transienten oder durch eine HF-Fehlanpassung - sind, ähnlich wie im ESD-Fall, die Emitter-Basis-Strecke und die Basis-Kollektor-Strecke am meisten gefährdet. Diese können durchbrechen, und ein lawinenartig ansteigender Strom kann eine irreversible Schädigung des Bauelements herbeiführen.

Bei den elektronischen Bauelementen, wie sie heutzutage mit immer kleiner werdenden Geometrien bei gleichzeitiger Zunahme der Integrationsdichte gefertigt und verwendet werden, besteht aufgrund der ansteigenden Empfindlichkeit eine Gefahr der Beschädigung oder Zerstörung derselben im Falle von elektrostatischen Entladungen. Die Bauelemente sind daher gegen solche elektrostatische Entladungen zu schützen, was zum einen durch eine entsprechende Handhabung derselben in Chipzonen erreicht werden kann, jedoch nur das Eintreten der elektrostatischen Entladung verhindert, ohne dass die Bauelemente selbst irgendwelche Schutzmaßnahmen aufweisen würden.

Kritische Bauelemente werden häufig durch externe, zusätzliche Komponenten geschützt. In integrierten Schaltungen nutzt man dazu meist Dioden ("Schutzdiode") in verschiedenen Ausführungsformen, oft als Doppeldiode in einer "back to back"-Anordnung. Eine solche Schutzdiode wird beispielsweise parallel zum sehr empfindlichen Gatekontakt eines MOS-Transistors gegen Masse verbunden. Im Fall einer Überspannung bricht sie durch und leitet damit die gefährdende ESD-Ladung zur Masse ab.

Bei Anwendungen im Mikrowellenbereich sind solche Schutzelemente allerdings unerwünscht, weil sie auf Grund ihrer parasitären Kapazitäten auch im Sperrfall die Hochfrequenzeigenschaften massiv beinträchtigen. Darüber hinaus wirken solche externen Schutzmaßnahmen nur begrenzt; in jedem Fall bleibt es sinnvoll, das aktive Bauelement auf optimale ESD-Festigkeit hin zu optimieren.

Neben diesen "passiven" Schutzmaßnahmen existieren im Stand der Technik Ansätze, die darauf abzielen, den Strom beim Eintreten eines ESD-Falles möglichst zu verteilen. Aus diesem Grund wird versucht, einen flächigen statt einen lokal begrenzten Durchbruch zu erreichen. Zu diesem Zweck wird der Entwurf/das Design des Halbleiterbauelements verrundet, da es in Ecken zu sphärischen Dotierstoffprofilen kommt, die zuerst durchbrechen. Gehen zylindrische Gebiete entlang von Kanten nicht schnell genug ebenfalls in den Durchbruch über, so kann dies zu einer thermischen Zerstörung des Halbleiterbauelements führen. Der Nachteil dieser Vorgehensweise besteht jedoch darin, dass die Optimierung lediglich auf oberflächennahe Teile des Halbleiterbauelements beschränkt ist.

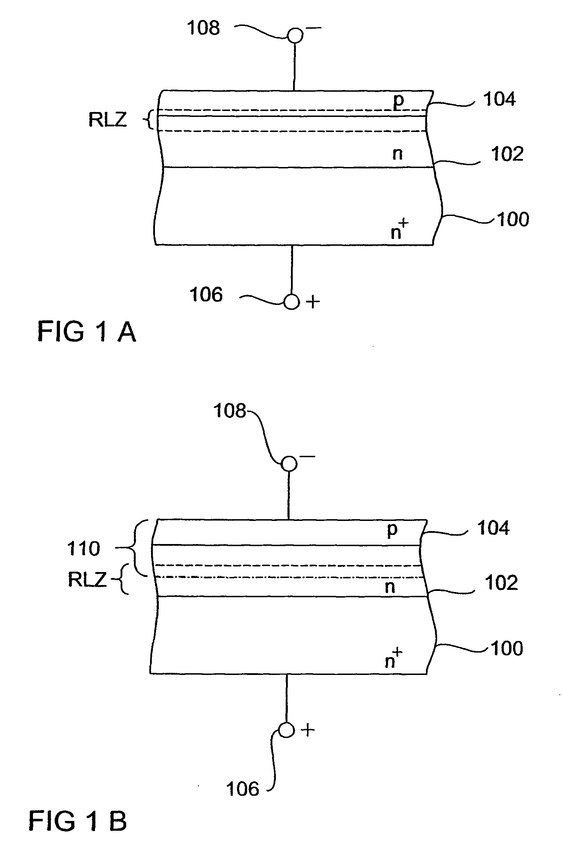

Nachfolgend seien die Auswirkungen eines ESD-Falles anhand einer beispielhaften Halbleiterstruktur näher erläutert. In Fig. 1A ist eine Halbleiterstruktur gezeigt, die ein hochdotiertes Substrat 100 aufweist, auf dem eine erste Schicht 102, beispielsweise eine Epitaxieschicht, aufgewachsen ist. Beispielhaft sei angenommen, dass auf der Epitaxieschicht 102 eine weitere Schicht 104 aufgewachsen sei. Die Schichten 102 und 104 sind niedrig dotiert. Die Schichten 100 und 102 sind vom n-Typ, wohingegen die Schicht 104 vom p-Typ ist, so dass sich an der Grenzfläche zwischen der ersten Schicht 102 und der zweiten Schicht 104 ein pn-Übergang einstellt, der in Fig. 1A in Sperrrichtung gepolt ist, wie dies durch die an den Anschlüssen 106 und 108 anliegende Polung schematisch dargestellt ist. In Fig. 1A ist ferner die Raumladungszone RLZ gezeigt, die sich um den pn-Übergang herum ausbildet. In Fig. 1A ist ein Zustand gezeigt, in dem kein ESD-Fall vorliegt.

Tritt ein ESD-Fall auf, so ist im Fall eines Durchbruchs die Stromstärke zwar zunächst sehr klein, durchläuft im weiteren ESD-Ereignis aber eine steile, im Test durch das Modell vorgegebene Kennlinie, so dass sehr bald nach Eintreten eines Durchbruchs Hochstromeffekte zum Tragen kommen. Beim ESD-Test gemäß dem Human Body Modell liegt z. B. der Strom nach wenigen Nanosekunden im Amperebereich. Da die durch den Avalanche-Effekt (Lawineneffekt) in der Raumladungszone erzeugten Ladungsträger zu jeder Zeit des HBM-Pulses den Strom tragen müssen, werden so viele Ladungsträger erzeugt, dass sich die Raumladungszone zum nächsten, hochdotierten Gebiet verschiebt. Dies wird beispielsweise von Yuan Taur u. a. in "Fundamentals of Modern VLSI Devices", Cambridge University Press, 1998, S. 320 bis 325, und von Bertrand G. u. a. in "Analysis and Compact Modeling of a Vertical Grounded-Base NPN Bipolar Transistor used as an ESD Protection in a Smart Power Technology", IEEE BCTM 1,2., 2000, S. 28 bis 31, näher erläutert.

In Fig. 1B, welche die Halbleiterstruktur aus Fig. 1A im ESD-Fall zeigt, ist dieser Zustand verdeutlicht. In Fig. 1B ist mit 110 ein erweiterter p-Bereich dargestellt, und wie zu erkennen ist, verschiebt sich die Raumladungszone RLZ an die Grenze des Übergangs von der ersten Schicht 102 zum Substrat 100.

Die oben beschriebene Auswirkung des Durchbruchs führt dazu, dass sich das elektrische Feld anschließend auf das Gebiet zwischen der Epitaxieschicht 102 und dem hochdotierten Substrat 100 konzentriert. An dieser Stelle treten im weiteren Verlauf des ESD-Ereignisses die höchsten Felder auf, so dass hier das eigentliche ESD-Ereignis stattfindet.

In Anbetracht der obigen Ausführungen werden die Nachteile der oben beschriebenen Ansätze zur Verteilung des Stroms im ESD-Fall deutlich, da zu erkennen ist, dass die ESD-Festigkeit relativ wenig von technologischen Maßnahmen an der Oberfläche beeinflusst werden kann.

Ähnliche Effekte, wie sie oben anhand des ESD-Ereignis bei Halbleiterstrukturen angetroffen werden, werden auch bei Halbleiterstrukturen angetroffen, die beispielsweise in einer Leistungsendstufe angeordnet sind und Überspannungen oder Stromimpulsen ausgesetzt sind, die beispielsweise aufgrund von Transienten auf einer Versorgungsleitung oder aufgrund einer Fehlanpassung der Halbleiterstruktur entstehen können.

Die JP 2000-058870 A beschreibt ein Halbleiterbauelement einer verbesserten ESD-Festigkeit, wobei das Bauelement ein n⁺-Substrat umfasst, auf dem eine n⁻-Schicht gebildet ist, in der wiederum eine p⁺-Wanne eingebracht ist.

Die US 6,232,822 B1 beschreibt ein Halbleiterbauelement, insbesondere einen Bipolartransistor, bei dem auf einem p-Substrat eine vergrabene n⁺-Schicht gebildet ist, auf der wiederum einen n-Kollektorschicht angeordnet ist, in der ihrerseits eine Basisschicht eingebracht ist. In der Basisschicht ist eine Emitterschicht gebildet. Ausgehend von einer Dotierung in der n-Kollektorschicht steigt die n-Dotierung allmählich zu der 'n⁺-Dotierung in der vergrabenen Schicht an.

Ausgehend von diesem Stand der Technik liegt der vorliegen-den Erfindung die Aufgabe zugrunde, eine Halbleiterstruktur mit einer verbesserten ESD- und Überlast-Festigkeit sowie ein Verfahren zur Herstellung derselben zu schaffen.

Diese Aufgabe wird durch eine Haltrleiterstruktur nach Anspruch 1 und durch ein Verfahren nach Anspruch 9 gelöst.

Gemäß einem Ausführungsbeispiel umfasst die Grundschicht eine Substratschicht und eine Pufferschicht. Vorzugsweise ist die erste Schicht niedriger dotiert als die Pufferschicht. Die erste Schicht wird als aktiver Bereich der Halbleiterstruktur benutzt. Die Pufferschicht wird lediglich im Überlastfall mit hohen Feldstärken belastet. Bei einem bevorzugten Ausführungsbeispiel verläuft das Dotierprofil ausgehend von etwa 10¹⁶ Atome/cm³ im Bereich der ersten Schicht über etwa 10¹⁷ Atome/cm³ bis etwa 10¹⁸ Atome/cm³ in der Pufferschicht zu etwa 10¹⁹ Atome/cm³ im Bereich der Substratschicht.

Bei einem Ausführungsbeispiel wird in der ersten Schicht ein aktiver Kollektor eines Transistors gebildet, und in der zweiten Schicht wird eine Basis und ein Emitter des Transistors gebildet, wobei der Transistor ein Leistungstransistor sein kann. Der Transistor kann ein Bipolartransistor oder ein Feldeffekttransistor sein. Alternativ kann in der ersten Schicht und in der zweiten Schicht eine Diode gebildet sein.

Der vorliegenden Erfindung liegt die Erkenntnis zugrunde, dass eine Verteilung des Stroms durch Maßnahmen an der Oberfläche eines Halbleiterbauelements die ESD-Festigkeit desselben nur marginal beeinflusst, da im ESD-Fall der Durchbruch ohnehin zum Übergang von Epitaxieschicht/Substrat bzw. Epitaxieschicht/Buried Layer - und damit in die Fläche - verschoben wird. Hinsichtlich der gerade genannten Terminologie wird darauf hingewiesen, dass bei Bipolartransistoren, welche unter Verwendung von IC-Technologien (IC = integrated circuit = integrierte Schaltung) hergestellt werden, das Substrat dem "Buried Layer" entspricht. Der Einfachheit halber wird im Verlauf der nachfolgenden Beschreibung der vorliegenden Erfindung immer von dem Substrat gesprochen werden, wobei die Prinzipien der vorliegenden Erfindung auch auf IC-Bauelemente anwendbar sind.

Anstelle der auf die Oberfläche der Halbleiterstruktur begrenzten Maßnahmen, welche, wie erwähnt, nur eine marginale Beeinflussung der ESD-Festigkeit zur Folge haben, lehrt die vorliegende Erfindung, dass in der Tiefe des Halbleiterbauelements, am Übergang von Epitaxieschicht zu Substrat, einzugreifen ist.

Nachdem die Steilheit eines Dotierstoffprofils an dem Übergang die dort auftretenden elektrischen Felder bestimmt, wird hierdurch auch, sofern keine anderen technologischen Schwächen vorliegen, die den Einfluss überdecken, die ESD-Festigkeit erheblich beeinflusst. Je langsamer das Dotierungsprofil zum Substrat ansteigt, desto weiter muss die Raumladungszone in das Substrat hinein reichen, so dass bei konstanter Sperrspannung bzw. bei konstantem Strom ein niedriges, maximales elektrisches Feld anliegt, und sich somit eine erhöhte ESD-Festigkeit einstellt.

Gemäß der vorliegenden Erfindung lassen sich abhängig von der Flachheit des Profils am Übergang ESD-Festigkeiten eines pn-Übergangs, wie er sich beispielsweise entlang der Basis-Kollektor-Strecke eines Hochfrequenzbipolartransistors ergibt, zwischen 300 V und 3.900 V erreichen.

Gemäß einem ersten Ausführungsbeispiel der vorliegenden Erfindung wird der Effekt eines flachen Dotierstoffprofils dadurch erreicht, dass der Übergang zwischen der Epitaxieschicht und Substrat nach dem Aufwachsen der Epitaxieschicht und gegebenenfalls nach dem Bilden weiterer Strukturen einer Wärmebehandlung ausgesetzt wird, so dass das Dotierstoffprofil am Übergang abgeflacht wird. Bei einem alternativen Ausführungsbeispiel wird die Abflachung des Profils ohne thermische Behandlung nur durch eine ganzflächige Implantation in das Substrat erreicht.

Bei wiederum einem anderen bevorzugten Ausführungsbeispiel wird der Effekt eines flachen Übergangs durch einen stufenförmigen Verlauf des Dotierstoffprofils erreicht.

Im Stand der Technik wurde bisher so gut wie gar nichts zum Thema Substrat/ESD-Festigkeit publiziert, wobei in diesem Zusammenhang auf die Veröffentlichung von Amerasekera A. u. a., "ESD in Silicon Integrated Circuits", John Wiley & Sons, 1995, S. 186 bis 188, verwiesen wird. Der große Einfluss des Dotierstoffprofils am Übergang von Epitaxieschicht zu Substrat auf ESD-Festigkeit wurde bisher nicht erkannt. Zwar wird beschrieben, dass im ESD-Fall das Feld in Richtung Substrat verschoben wird, es wurde aber nicht erkannt, dass dieses Gebiet dadurch für ESD-verbessernde Eingriffe relevant ist. Insbesondere sind keine technologischen Maßnahmen bekannt, die sich aus dieser Erkenntnis zur Erhöhung der ESD-Festigkeit ableiten ließen. Es sind keine konkreten Vorschläge hinsichtlich eines ESD-optimierten Übergangs von Epitaxieschicht zu Substrat bekannt.

Versuche, die im Zusammenhang mit der vorliegenden Erfindung durchgeführt wurden, haben ergeben, dass die relativ schlechte ESD-Festigkeit moderner Technologien nicht nur auf das Ergebnis der mit der Miniaturisierung immer kleiner werdenden Kapazitäten, wie dies oft ausgeführt wird, zurück zu führen ist, sondern hauptsächlich das Ergebnis des bei der Herstellung der Halbleiterstrukturen verwendeten niedrigen Temperaturbudgets ist, was zu steilen Profilen am Übergang von Epitaxieschicht zu Substrat führt.

Gemäß einem weiteren Aspekt schafft die vorliegende Erfindung eine Halbleiterstruktur, bei der die Grundschicht eine Substratschicht und eine Pufferschicht umfasst, wobei das Dotierprofil ausgehend von etwa 10¹⁶ Atome/cm³ im Bereich der ersten Schicht über etwa 10¹⁷ Atome/cm³ bis etwa 10¹⁸ Atome/cm³ in der Pufferschicht zu etwa 10¹⁹ Atome/cm³ im Bereich der Substratschicht verläuft. Bei einem Ausführungsbeispiel ist in der ersten Schicht ein aktiver Kollektor eines Transistors gebildet, und in der zweiten Schicht ist eine Basis und ein Emitter des Transistors gebildet, wobei der Transistor ein Leistungstransistor sein kann. Der Transistor kann ein Bipolartransistor oder ein Feldeffekttransistor sein. Alternativ ist in der ersten Schicht und in der zweiten Schicht eine Diode gebildet.

Dem gerade beschriebenen Aspekt liegt die Erkenntnis zugrunde, dass die oben im Zusammenhang mit dem ESD-Fall gelehrten Ansätze zur Verbesserung der ESD-Festigkeit von Transistoren durch die Bereitstellung eines stufenförmigen Dotierstoffprofils auch bei Leistungsbauelementen anwendbar sind, bei denen aufgrund von auftretenden Überspannungen am Ausgang solcher Halbleiterstrukturen ähnliche Effekte wie im ESD-Fall auftreten.

Bevorzugte Ausführungsbeispiele werden nachfolgend anhand der beiliegenden Zeichnungen näher erläutert. Es zeigen:
Fig. 1A eine herkömmliche Halbleiterstruktur mit einem gesperrten pn-Übergang;
Fig. 1B die in Fig. 1A gezeigte Halbleiterstruktur im ESD-Fall;
Fig. 2 eine Halbleiterstruktur gemäß der vorliegenden Erfindung im ESD-Fall;
Fig. 3 einen Graphen, der das Dotierstoffprofil der Halbleiterstruktur gemäß einem ersten nicht beanspruchten Ausführungsbeispiel zeigt;
Fig. 4 einen Graphen, der das Dotierstoffprofil der Halbleiterstruktur gemäß einem zweiten nicht beanspruchten Ausführungsbeispiel zeigt; und
Fig. 5 einen Graphen, der das Dotierstoffprofil der Halbleiterstruktur gemäß einem dritten Ausführungsbeispiel zeigt.

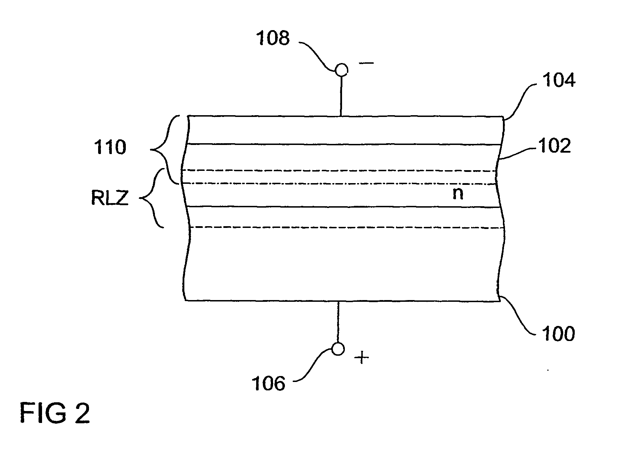

In Fig. 2 ist die Auswirkung einen Verflachung des Dotierstoffprofils am Übergang von Epitaxieschicht zu Substrat im ESD-Fall dargestellt.

Wie aus Fig. 2 im Vergleich zu Fig. 1B zu erkennen ist, wird eine Erstreckung der Raumladungszone RLZ in das Substrat 100 erreicht, so dass sich bei konstanter Sperrspannung ein niedrigeres, maximales elektrisches Feld einstellt und damit eine höhere ESD-Festigkeit.

Es existieren verschiedene Möglichkeiten, den Verlauf des Dotierstoffprofils am Übergang von Epitaxieschicht 102 zu Substrat 100 zu verändern, um die Raumladungszone zu verschieben.

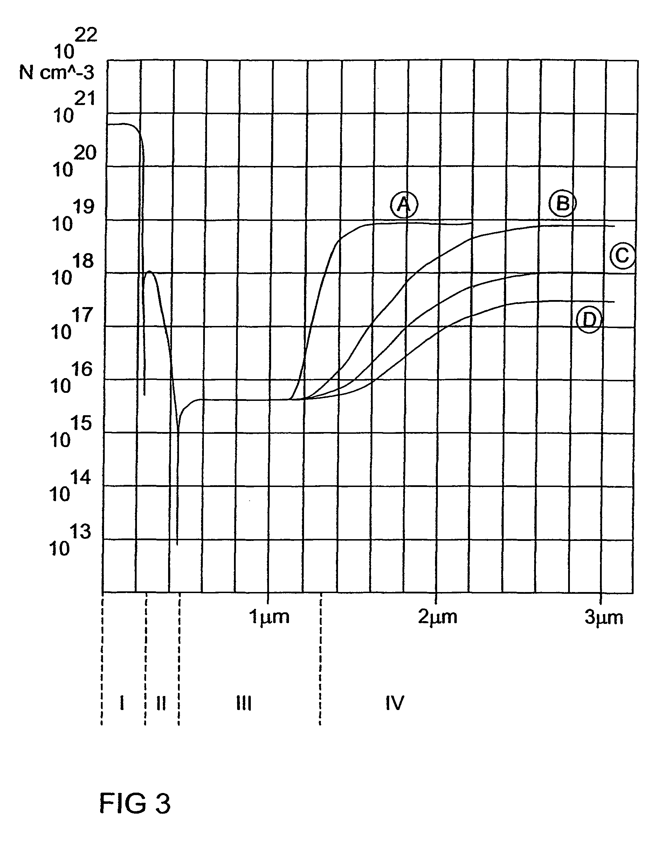

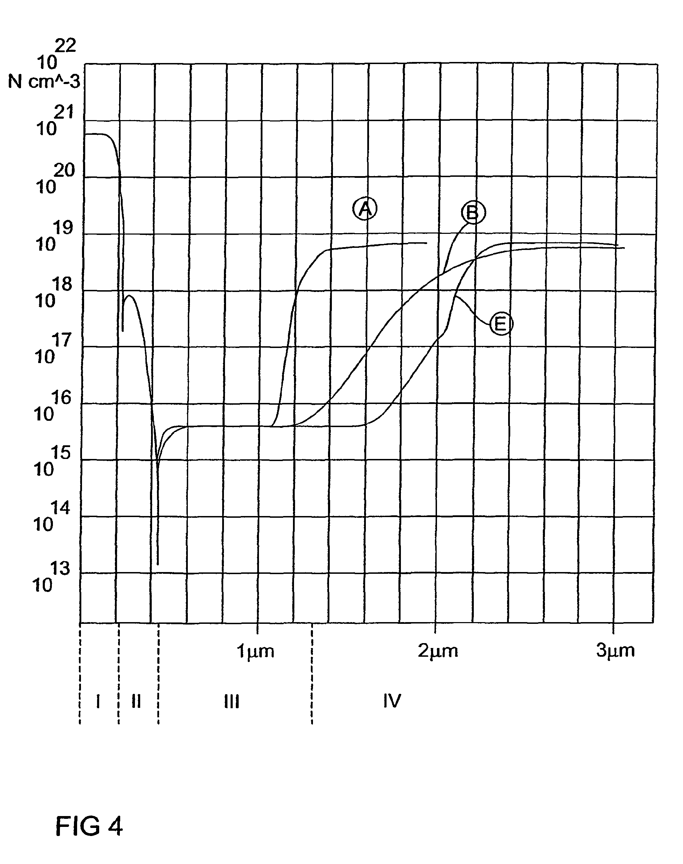

Gemäß einem ersten Ausführungsbeispiel wird der Verlauf des Dotierstoffprofils am Übergang von Epitaxieschicht zu Substrat verflacht, und anhand der Fig. 3 und 4 werden zwei Möglichkeiten für eine solche Verflachung näher erläutert. Das 1 und 2 Ausführungbeispiel, die in den Fig. 3 und 4 offenbart werden, sind nicht Teil der Erfindung. In Fig. 3 ist der Verlauf der Dotierstoffkonzentration eines Hochfrequenztransistors über der Entfernung von einer Oberfläche einer Halbleiterstruktur aufgetragen, wobei diese Halbleiterstruktur zusätzlich zu der in Fig. 2 gezeigten Struktur eine als n-Emitter wirkende n-Schicht auf der p-Schicht 104 aufweist, die hochdotiert ist. In Fig. 3 sind vier Abschnitte I, II, III und IV gezeigt. Der Bereich I zeigt den Dotierstoffverlauf im Bereich der gerade erwähnten zusätzlichen n-Schicht. Der Bereich II zeigt den Verlauf der p-Dotierung in der p-Schicht 104. Der Bereich III zeigt den Verlauf der n-Dotierung in der Epitaxieschicht 102 und der Bereich IV zeigt den Verlauf der n-Dotierung in dem Bereich des Substrats. Für den Gegenstand der vorliegenden Erfindung ist der Übergang des Bereichs III auf den Bereich IV von Interesse. Eine erste Kurve A zeigt den Verlauf einer herkömmlichen Halbleiterstruktur, ähnlich zu der in Fig. 1A gezeigten, mit einem Substrat, das mit Arsen (As) dotiert ist, und einen Widerstand von 7 mΩcm hat. Der Verlauf des Dotierstoffprofils A ist sehr steil, wie sich aus Fig. 3 ergibt. Ausgehend von der Dotierung von etwa 5 x 10¹⁵ Ncm⁻³ steigt die Dotierstoffkonzentration über eine Länge von etwa 0,5 µm auf die hohe Dotierung im Bereich des Substrats IV von etwa 10¹⁹ Ncm⁻³ an. Dieser steile Verlauf des Dotierstoffprofils führt zu den oben beschriebenen Problemen bei herkömmlichen Halbleiterstrukturen. Der Widerstand des Substrats liegt vorzugsweise zwischen 5 mΩcm und 10 mΩcm.

Gemäß einem ersten Ausführungsbeispiel wird das Gesamttemperaturbudget bei der Herstellung der Halbleiterstruktur angehoben, wobei im Prozessfluss während der Herstellung der Halbleiterstruktur Möglichkeiten gegeben sind, um solche Temperungen ohne weiteres einzufügen, ohne dass der Gesamtprozess störend beeinflusst würde. Wichtig ist lediglich, dass zum Zeitpunkt der Temperung(en) die Epitaxieschicht 102 bereits auf dem Substrat 100 aufgewachsen ist. Gemäß einem Ausführungsbeispiel der vorliegenden Erfindung wurde eine ESD-Temperung nach einem Aufwachsen eines Feldoxids in den Prozess eingefügt.

In Fig. 3 sind mit den Kurven B, C und D drei Ausführungsbeispiele dargestellt. Die Kurve B zeigt den Verlauf des Dotierstoffprofils für den Fall eines mit Arsen (As) dotierten Substrats, das einen Widerstand von 7 mΩcm hat. Die Kombination aus Epitaxieschicht und Substrat wurden nach dem Aufwachsen der Epitaxieschicht auf dem Substrat einer Wärmebehandlung bei einer Temperatur von etwa 1.150°C für eine Zeitdauer von etwa 60 Minuten unterzogen. Diese ESD-Temperung führte zu dem in Fig. 3 bei B gezeigten Verlauf des Dotierstoffprofils. Wie zu erkennen ist, steigt das Dotierstoffprofil verglichen mit der Kurve A weniger steil, also flacher, an. Ausgehend von der Dotierung in der Epitaxieschicht (III) von etwa 5 x 10¹⁵ Ncm⁻³ steigt die Dotierungskonzentration über eine Länge von etwa 1,25 µm auf den Endwert im Bereich des Substrats von etwa 10¹⁹ Ncm⁻³ an. Die ESD-Festigkeit, die sich bei einem Dotierstoffprofil gemäß der Kurve B ergibt, liegt bei etwa 2.700 Volt.

Die Kurve B beschreibt das Dotierstoffprofil bei einem niederohmigen Substrat. Gemäß einem Ausführungsbeispiel der vorliegenden Erfindung wird ein hochohmiges Substrat verwendet, da der Übergang bei gleichem Temperaturbudget um so flacher ausfällt, je hochohmiger das Substrat ist. Dies ist in Fig. 3 anhand der Kurven C und D dargestellt.

Die Kurve C beschreibt den Verlauf des Dotierstoffprofils für ein Substrat, das mit Antimon (Sb) dotiert wurde, um einen Widerstand von 20 mΩcm zu haben, wobei auch hier die ESD-Temperung bei einer Temperatur von etwa 1.150°C für etwa 60 Minuten erfolgte. Die Kurve D zeigt den Verlauf des Dotierstoffprofils für ein mit Antimon dotiertes Substrat, welches einer ESD-Temperung bei 1.150°C für 60 Minuten ausgesetzt war, jedoch anders als bei der Kurve C einen Widerstand von 40 mΩcm hat. Wie zu erkennen ist, wird der Übergang flacher, je höherohmig das Substrat ist. Die ESD-Festigkeit liegt bei einem Dotierprofil gemäß der Kurve C bei 3.900 Volt.

Gemäß einem weiteren Ausführungsbeispiel kann eine Verflachung des Dotierstoffprofils auch durch eine ganzflächige Implantation in Substrat erreicht werden. Die Implantation erfolgt vor dem Aufbringen der Epitaxieschicht vorzugsweise mit einer schnell diffundierenden Spezies, z. B. Phosphor in einem Arsen dotierten Substrat. Da es nur auf die Steilheit des Übergangs ankommt, ist die Lösung im Ergebnis gleichwertig. In Fig. 4 ist der Dotierungsverlauf in einer solchen Situation durch die Kurve E dargestellt. Zu Vergleichszwecken sind die Kurven A und B, die bereits anhand der Fig. 3 beschrieben wurden, nochmals dargestellt. Um den Dotierungsverlauf gemäß der Kurve E zu erreichen, wurde ein mit Arsen dotiertes Substrat anstelle der ESD-Temperung einer Implantation ausgesetzt, wobei bei dem in Fig. 4 dargestellten Dotierungsverlauf E ein Arsen dotiertes Substrat anstelle einer ESD-Temperung einer Implantation von Phosphor ausgesetzt wurde, wobei Phosphor mit einer Dichte von 1 x 10¹³ Atomen/cm³ bis 1 x 10¹⁴ Atomen/cm³, vorzugsweise von 2 x 10¹³ Atomen/cm³ bei einer Implantationsenergie von 10 KeV in das Arsen dotierte Substrat eingebracht wurde. Ein Vergleich mit der Kurve A zeigt, dass auch hier eine Verflachung des Dotierstoffprofils erreicht werden kann.

Gemäß einem dritten Ausführungsbeispiel, das Teil der vorliegenden Erfindung ist, wird der Übergang zwischen Epitaxieschicht und Substrat stufenförmig hinsichtlich des Dotierstoffverlaufs ausgebildet, so dass die Raumladungszone im normalen Betrieb, beispielsweise eines Transistors, am Fuß der Stufe anstößt. Im ESD-Fall, also im Hochstromfall, wird die Stufe überschwemmt und die Raumladungszone stößt erst weiter hinten am Ende Stufe an, was genau wie bei einem flachen Übergang von Epitaxieschicht zu Substrat die Raumladungszone aufweitet und das maximale Feld erniedrigt. Hinsichtlich der Dimensionierung ist jedoch darauf zu achten, dass die Stufe nicht schon bei Strömen im Normalbetrieb überschwemmt wird, um eine unnötige Verschlechterung der Parameter der Halbleiterstruktur, beispielsweise des Transistors, zu vermeiden.

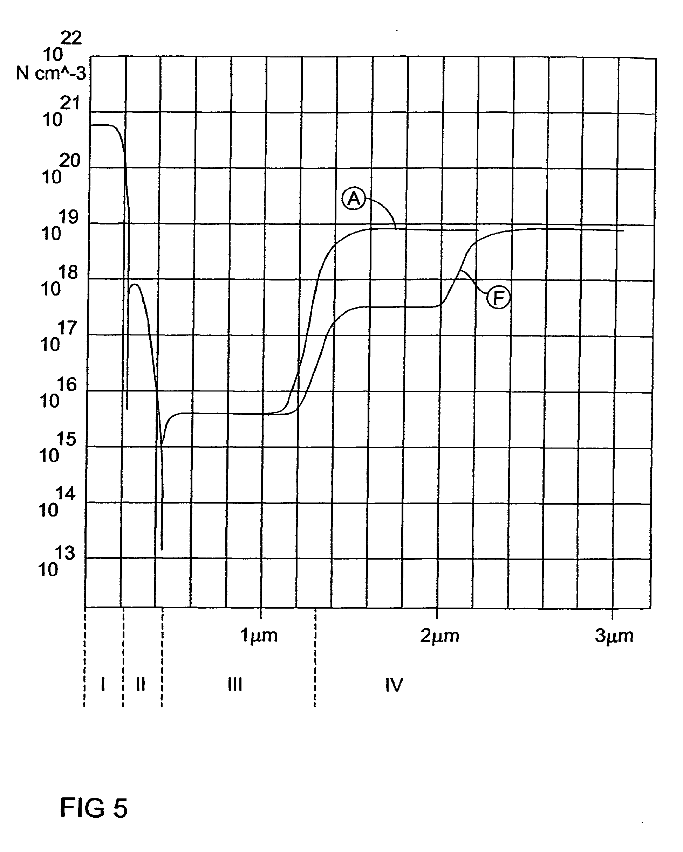

In Fig. 5 ist dieser stufenförmige Verlauf des Dotierstoffprofils anhand der Kurve F näher dargestellt, wobei zu Vergleichszwecken die in Fig. 3 beschriebene Kurve A, welche den Dotierungsverlauf ohne ESD-Temperung darstellt, wiedergegeben ist. Wie zu erkennen ist, steigt die Dotierstoffkonzentration ausgehend von der Epitaxieschicht zunächst von etwa 5 x 10¹⁵ Ncm⁻³ auf etwa 5 x 10¹⁷ Ncm⁻³ an. Im Normalbetrieb erstreckt sich die Raumladungszone nicht in den Bereich der Dotierung von 5 x 10¹⁷ Ncm⁻³ hinein. Ausgehend von dieser Dotierung steigt die Dotierungskonzentration weiter auf die abschließende Konzentration von 10¹⁹ Ncm⁻³ an, und im ESD-Fall kann sich, aufgrund der Stufe, die Raumladungszone weiter in das Substrat hinein erstrecken, und zwar im Bereich, in dem die Dotierung bei 5 x 10¹⁷ Ncm⁻³.

Wie aus der obigen Erläuterung deutlich wird, muss das flachere Dotierstoffprofil am Übergang von Epitaxieschicht zu Substrat also nicht zwingend durch ESD-Temperungen erzeugt werden, sondern stattdessen kann die oben beschriebene Substratimplantation oder der stufenförmige Profilverlauf gewählt werden. Die Substratimplantation stellt eine interessante Alternative zur ESD-Temperung dar, da diese unter Verwendung einer Phototechnik lokal eingebracht werden kann. Die anhand der Fig. 3 und 4 beschriebenen Mechanismen zur Abflachung des Dotierstoffprofils am Übergang von Epitaxieschicht zu Substrat können u.U. manche Parameter, wie z. B. C(u), des Halbleiterelements verschlechtern, wobei jedoch keine Verschlechterung in dem Maße eintritt, dass die Maßnahmen nicht mehr eingesetzt werden könnten.

Demgegenüber ist die "Stufenepitaxie" (siehe Fig. 5) sehr interessant, da bei einer geeigneten Wahl der Stufenhöhe die Transistoreigenschaften oder die Eigenschaften des Halbleiterbauelements im Normalbetrieb nicht verändert werden.

Die oben beschriebene Verbesserung der ESD-Festigkeit unter Verwendung einer Stufenepitaxie kann bei HF-Transistoren als Pufferschicht zwischen dem Substrat und dem aktiven Kollektor des HF-Transistors angesehen werden. Eine durch die Pufferschicht gebildete Stufenepitaxie ist auch bei der Anwendung der Halbleiterstruktur in Leistungs-Endstufen, zum Beispiel für den Mobilfunk (GSM, UMTS, usw.) sehr vorteilhaft. Bei diesen Anwendungen kommt es im wesentlichen darauf an, dass das Bauelement Überspannungen und eine Stromüberlast am Ausgang desselben oder am Ausgang einer Endstufe ohne Zerstörungen übersteht. Solche Überlastungen können als Transienten auf der Versorgungsleitung oder durch eine Fehlanpassung im HF-Bereich entstehen. Dieser Belastungsfall ist dem ESD-Ereignis ähnlich, und folglich wirken auch hier die gleichen Maßnahmen zur Stabilisierung.

Bei einem weiteren Ausführungsbeispiel der vorliegenden Erfindung wird eine Halbleiterstruktur geschaffen, bei der die Grundschicht IV eine Substratschicht und eine Pufferschicht umfasst , wobei das Dotierprofil F (siehe Fig. 5) ausgehend von etwa 10¹⁶ Atome/cm³ im Bereich der ersten Schicht III über etwa 10¹⁷ Atome/cm³ bis etwa 10¹⁸ Atome/cm³ in der Pufferschicht (Bereich IV bis 2µm in Fig. 5) zu etwa 10¹⁹ Atome/cm³ im Bereich der Substratschicht (Bereich IV ab 2µm in Fig. 5) verläuft.

Die Halbleiterstruktur kann ein Transistor oder eine Diode sein. Ist die Halbleiterstruktur ein Transistor, so ist in der ersten Schicht 102 (siehe Fig. 2) ein aktiver Kollektor (siehe Bereich III in Fig. 5) gebildet und in der zweiten Schicht (siehe Fig. 2) eine Basis (siehe Bereich II in Fig. 5) und ein Emitter (siehe Bereich I in Fig. 5) gebildet. Der Transistor kann ein Leistungstransistor sein und als Bipolartransistor oder als Feldeffekttransistor ausgebildet sein.

Bei der Herstellung einer solchen Halbleiterstruktur mit einer verbesserten Überspannungs-Festigkeit, wie sie beispielsweise in einer GSM-Leistungsendstufe eingesetzt wird, ist es aufgrund der Differenz bzw. Wechselwirkungen mit anderen Bauelementen nicht möglich, die Pufferschicht oder Pufferstufe in der erforderlichen Dotierungshöhe homogen epitaktisch abzuscheiden.

Erfindungsgemäß wird daher zunächst eine undotierte bzw. niedrig dotierte Pufferschicht auf der bereitgestellten Substratschicht mit einer Dotierung vorzugsweise zwischen undotiert und bis zu etwa 10¹⁷ Atome/cm³ abgeschieden, und das stufenförmige Dotierprofil wird durch eine lokale Implantation von Dotierstoffen unter dem zu bildenden Transistor oder unter der zu bildenden Diode erzeugt. Abschließend werden die erste Schicht 102 und die zweite Schicht 104 abgeschieden, und der Transistor oder die Diode wird erzeugt.

Die Dotierung der Pufferschicht ist vom gleichen oder entgegengesetzten Typ wie die der Substratschicht. Das Erzeugen des stufenförmigen Dotierprofils durch die lokale Implantation in der Pufferschicht bewirkt eine Dotierung vom ersten Leitfähigkeitstyp im Bereich von etwa 10¹⁷ Atome/cm³ bis etwa 10¹⁸ Atome/cm³.

Obwohl die zweite Schicht 104 als auf der ersten Schicht abgeschiedene Schicht beschrieben wurde, ist die vorliegende Erfindung nicht hierauf beschränkt. Die zweite Schicht kann im Sinne der vorliegenden Erfindung auch durch in der ersten Schicht 102 gebildete Bereiche, z.B. aktive Bereiche für das Bauelement (Basis, Emitter), gebildet sein. In diesem Fall wird die zweite Schicht 104 z.B. durch eine Erzeugung von Wannen in der ersten Schicht gebildet, z.B. durch eine Implantation.

Obwohl die Ausführungsbeispiele anhand einer Struktur beschrieben wurden, welche ein n-Substrat, eine n-Epitaxieschicht und eine p-Schicht aufweisen, ist die vorliegende Erfindung nicht auf eine solche Halbleiterstruktur beschränkt. Vielmehr können die Erkenntnisse der vorliegenden Erfindung auch auf Strukturen angewandt werden, die eine p-Epitaxieschicht auf einem p-Substrat haben, wobei eine n-Schicht auf der p-Epitaxieschicht aufgebracht ist.

Die vorliegende Erfindung ist nicht auf die oben genannten Dotierstoffe beschränkt, sondern vielmehr sind andere geeignete Dotierstoffe ebenfalls einsetzbar.

### Bezugszeichenliste

- 100: Substrat
- 102: erste Schicht
- 104: weitere Schicht
- 106: Anschluss
- 108: Anschluss
- 110: erweiterter p-Bereich
- RLZ: Raumladungszone
- A,B,C,D: Kurvenverläufe
- I, II, III, IV: Abschnitte der Halbleiterstruktur

## Patentansprüche

1. Halbleiterstruktur mit
einer Grundschicht (100, IV) von einem ersten Leitfähigkeitstyp;
einer ersten Schicht (102, III) von dem ersten Leitfähigkeitstyp, die auf der Grundschicht (100) angeordnet ist und eine Dotierstoffkonzentration aufweist, die niedriger ist als eine Dotierstoffkonzentration der Grundschicht (100, IV); und
einer zweiten Schicht (104, II) von einem zweiten Leitfähigkeitstyp, die mit der ersten Schicht (102, III) zusammenwirkt, um einen Übergang zwischen dem ersten Leitfähigkeitstyp und dem zweiten Leitfähigkeitstyp zu bilden;
**dadurch gekennzeichnet, dass**
ein Verlauf (F) eines Dotierstoffprofils an dem Übergang zwischen der Grundschicht (100, IV) und der ersten Schicht (102, III) ausgehend von einer ersten Dotierstoffkonzentration in der ersten Schicht (102, III) über eine zweite Dotierstoffkonzentration in der Grundschicht (100, IV) zu einer dritten Dotierstoffkonzentration in der Grundschicht (100, IV) stufenförmig eingestellt ist, wobei die dritte Dotierstoffkonzentration höher ist als die erste Dotierstoffkonzentration und die zweite Dotierstoffkonzentration, und wobei die zweite Dotierstoffkonzentration höher ist als die erste Dotierstoffkonzentration.

2. Halbleiterstruktur gemäß Anspruch 1, bei der die erste Dotierstoffkonzentration 10¹⁶ Atome/cm³, die zweite Dotierstoffkonzentration 10¹⁷ Atome/cm³ und die dritte Dotierstoffkonzentration 10¹⁹ Atome/cm³ ist.

3. Halbleiterstruktur nach Anspruch 1 oder 2, bei der die Grundschicht ein Substrat oder eine vergrabene Schicht.ist.

4. Halbleiterstruktur nach Anspruch 1 oder 2, bei der die Grundschicht (100, IV) eine Substratschicht und eine Pufferschicht umfasst, wobei das Dotierprofil (F) ausgehend von 10¹⁶ Atome/cm³ im Bereich der ersten Schicht (102, III) über 10¹⁷ Atome/cm³ bis 10¹⁸ Atome/cm³ in der Pufferschicht in der Grundschicht (100, IV) zu 10¹⁹ Atome/cm³ im Bereich der Substratschicht in der Grundschicht (100, IV) verläuft.

5. Halbleiterstruktur nach Anspruch 4, bei der in der ersten Schicht (102, III) ein aktiver Kollektor eines Transistors gebildet ist, und bei der in der zweiten Schicht (104, II) eine Basis und ein Emitter des Transistors gebildet sind.

6. Halbleiterstruktur nach Anspruch 5, bei der der Transistor ein Leistungstransistor ist.

7. Halbleiterstruktur nach Anspruch 5 oder 6, bei der der Transistor ein Bipolartransistor oder ein Feldeffekttransistor ist.

8. Halbleiterstruktur nach Anspruch 3, bei der in der.ersten Schicht (102, III) und in der zweiten Schicht (104, II) eine Diode gebildet ist.

9. Verfahren zur Verbesserung der ESD-Festigkeit und der Überlastfestigkeit einer Halbleiterstruktur, wobei die Halbleiterstruktur eine Grundschicht (100, IV) von einem ersten Leitfähigkeitstyp, eine erste Schicht (102, III) von dem ersten Leitfähigkeitstyp, die auf der Grundschicht (100, IV) angeordnet ist und eine Dotierstoffkonzentration aufweist, die niedriger ist als eine Dotierstoffkonzentration der Grundschicht (100, IV), und eine zweite Schicht (104, II) von einem zweiten Leitfähigkeitstyp umfasst, wobei die ersten Schicht (102, III) und die zweite Schicht (104, II) zusammenwirken, um einen Übergang zwischen dem ersten Leitfähigkeitstyp und dem zweiten Leitfähigkeitstyp zu bilden,
**gekennzeichnet durch** folgenden Schritt:
stufenförmiges Einstellen eines Verlaufs des Dotierstoffprofils (B, C, D, E) an dem Übergang zwischen der Grundschicht (100, IV) und der ersten Schicht (102, III) ausgehend von einer ersten Dotierstoffkonzentration in der ersten Schicht (102, III) über eine zweite Dotierstoffkonzentration in der Grundschicht (100, IV) zu einer dritten Dotierstoffkonzentration in der Grundschicht (100, IV), wobei die dritte Dotierstoffkonzentration höher ist als die erste Dotierstoffkonzentration und die zweite Dotierstoffkonzentration, und wobei die zweite Dotierstoffkonzentration höher ist als die erste Dotierstoffkonzentration.

10. Verfahren gemäß Anspruch 9, bei dem die erste Dotierstoffkonzentration 10¹⁶ Atome/cm³, die zweite Dotierstoffkonzentration 10¹⁷ Atome/cm³ und die dritte Dotierstoffkonzentration 10¹⁹ Atome/cm³ ist.

11. Verfahren nach Anspruch 9 oder 10, bei der die Grundschicht ein Substrat oder eine vergrabene Schicht ist.

12. Verfahren nach Anspruch 10 oder 11, bei dem die Grundschicht (100, IV) eine Substratschicht und eine Pufferschicht umfasst, wobei das Dotierprofil (F) ausgehend von 10¹⁶ Atome/cm³ im Bereich der ersten Schicht (102, III) über 10¹⁷ Atome/cm³ bis 10¹⁸ Atome/cm³ in der Pufferschicht in der Grundschicht (100, IV) zu 10¹⁹ Atome/cm³ im Bereich der Substratschicht in der Grundschicht (100, IV) verläuft.

13. Verfahren nach Anspruch 12, bei der ein Bereich der ersten Schicht (102, III) einen aktiven Kollektor eines Transistors bildet, und bei der in der zweiten Schicht (104, II) eine Basis und ein Emitter des Transistors gebildet sind, wobei die zweite Schicht auf der ersten Schicht abgeschieden ist oder durch eingebrachte Bereiche in der ersten Schicht gebildet ist.

14. Verfahren nach Anspruch 13, bei dem der Transistor ein Leistungstransistor ist.

15. Verfahren nach Anspruch 13 oder 14, bei dem der Transistor ein Bipolartransistor oder ein Feldeffekttransistor ist.

16. Verfahren nach Anspruch 12, bei dem in der ersten Schicht (102, III) und in der zweiten Schicht (104, II) eine Diode gebildet ist.

17. Verfahren nach einem der Ansprüche 13 bis 16, mit folgenden Schritten:
Bereitstellen der Substratschicht der Grundschicht (100, IV);
Erzeugen der Pufferschicht auf der Substratschicht der Grundschicht (100, IV), wobei die Pufferschicht keine oder eine niedrige Dotierung aufweist;
Erzeugen des stufenförmigen Dotierprofils durch eine lokale Implantation von Dotierstoffen unter dem zu bildenden Transistor oder unter der zu bildenden Diode;
Erzeugen der ersten Schicht (102, III) auf der Pufferschicht;
Erzeugen der zweiten Schicht (104, II) durch Abscheiden der zweiten Schicht auf der ersten Schicht oder durch Erzeugten von aktiven Bereichen in der ersten Schicht; und
Erzeugen des Transistors oder der Diode.

18. Verfahren nach Anspruch 17, bei dem die Dotierung der Pufferschicht vom ersten Leitfähigkeitstyp oder vom zweiten Leitfähigkeitstyp ist, und bei dem im Schritt des Erzeugens des stufenförmigen Dotierprofils durch die lokale Implantation in der Pufferschicht eine Dotierung vom ersten Leitfähigkeitstyp im Bereich von 10¹⁷ Atome/cm³ bis 10¹⁸ Atome/cm³ erreicht wird.

19. Verfahren nach Anspruch 17 oder 18, bei dem das Erzeugen des Transistors das Ausbilden der Basis und des Emitters in der zweiten Schicht umfasst, wobei die erste Schicht als Kollektor wirksam ist.

## Claims

1. Semiconductor structure comprising:
a base layer (100, IV) of a first conductivity type:
a first layer (102, III) of the first conductivity type arranged on the base layer (100) and having a dopant concentration which is lower than a dopant concentration of the base layer (100, IV); and
a second layer (104, II) of a second conductivity type being operative with the first layer (102, III) in order to form a transition between the first conductivity type and the second conductivity type;
**characterized in that**
a course (F) of a dopant profile at the transition between the base layer (100, IV) and the first layer (102, III) is set in a stepped form starting from a first dopant concentration in the first layer (102, III) over a second dopant concentration in the base layer (100, IV) to a third dopant concentration in the base layer (100, IV), wherein the third dopant concentration is higher than the first dopant concentration and the second dopant concentration, and wherein the second dopant concentration is higher than the first dopant concentration.

2. Semiconductor structure according to claim 1, wherein the first dopant concentration is 10¹⁶ atoms/cm³, the second dopant concentration is 10¹⁷ atoms/cm³ and the third dopant concentration is 10¹⁹ atoms/cm³.

3. Semiconductor structure according to claim 1 or 2, wherein the base layer is a substrate or a buried layer.

4. Semiconductor structure according to claim 1 or 2, wherein the base layer (100, IV) includes a substrate layer and a buffer layer, wherein the dopant profile (F) passes starting from 10¹⁶ atoms/cm³ in the area of the first layer (102, III) over 10¹⁷ atoms/cm³ to 10¹⁸ atoms/cm³ in the buffer layer in the base layer (100, IV) to 10¹⁹ atoms/cm³ in the area of the substrate layer in the base layer (100, IV).

5. Semiconductor structure according to claim 4, wherein in the first layer (102, III) an active collector of a transistor is formed, and wherein in the second layer (104, II) a base and an emitter of the transistor are formed.

6. Semiconductor structure according to claim 5, wherein the transistor is a power transistor.

7. Semiconductor structure according to claim 5 or 6, wherein the transistor is a bipolar transistor or a field effect transistor.

8. Semiconductor structure according to claim 3, wherein a diode is formed in the first layer (102, III) and in the second layer (104, II).

9. Method for improving the ESD strength and the overload strength of a semiconductor structure, wherein the semiconductor structure comprises a base layer (100, IV) of a first conductivity type, a first layer (102, III) of the first conductivity type which is arranged on the base layer (100, IV) and comprises a dopant concentration which is lower than a dopant concentration of the base layer (100, IV), and a second layer (104, II) of a second conductivity type wherein the first layer (102, III) and the second layer (104, II) are operative in order to form a transition between the first conductivity type and the second conductivity type,
**characterized by** the following step:
step setting of a course of the dopant profile (B, C, D, E) at the transition between the base layer (100, IV) and the first layer (102, III) starting from a first dopant concentration in the first layer (102, III) over a second dopant concentration in the base layer (100, IV) to a third dopant concentration in the base layer (100, IV), wherein the third dopant concentration is higher than the first dopant concentration and the second dopant concentration, and wherein the second dopant concentration is higher than the first dopant concentration.

10. Method according to claim 9, wherein the first dopant concentration is 10¹⁶ atoms/cm³, the second dopant concentration is 10¹⁷ atoms/cm³ and the third dopant concentration is 10¹⁹ atoms/cm³.

11. Method according to claim 9 or 10, wherein the base layer is a substrate or a buried layer.

12. Method according to claim 10 or 11, wherein the base layer (100, IV) includes a substrate layer and a buffer layer, wherein the dopant profile (F) starts from 10¹⁶ atoms/cm³ in the area of the first layer (102, III) over 10¹⁷ atoms/cm³ to 10¹⁸ atoms/cm³ in the buffer layer in the base layer (100, IV) to 10¹⁹ atoms/cm³ in the area of the substrate layer in the base layer (100, IV).

13. Method according to claim 12, wherein an area of the first layer (102, III) forms an active collector of a transistor, and wherein in the second layer (104, II) a base and an emitter of the transistor are formed, wherein the second layer is deposited on the first layer or is formed by introduced areas in the first layer.

14. Method according to claim 13, wherein the transistor is a power transistor.

15. Method according to claim 13 or 14, wherein the transistor is a bipolar transistor or a field effect transistor.

16. Method according to claim 12, wherein in the first layer (102, III) and in the second layer (104, II) a diode is formed.

17. Method according to one of the claims 13 to 16, comprising the following steps:
providing the substrate layer of the base layer (100, IV);
generating the buffer layer on the substrate layer of the base layer (100, IV), wherein the buffer layer comprises no or a low doping;
generating the stepped dopant profile by a local implantation of dopants under the transistor to be formed or under the diode to be formed;
generating the first layer (102, III) on the buffer layer;
generating the second layer (104, II) by depositing the second layer on the first layer or by generating active areas in the first layer; and
generating the transistor or the diode.

18. Method according to claim 17, wherein the doping of the buffer layer is of the first conductivity type or the second conductivity type, and wherein in the step of generating the stepped dopant profile by the local implantation in the buffer layer a doping of the first conductivity type is achieved in the area from 10¹⁷ atoms/cm³ to 10¹⁸ atoms/cm³.

19. Method according to claim 17 or 18, wherein generating the transistor includes forming the base and the emitter in the second layer, wherein the first layer is operative as a collector.

## Revendications

1. Structure semi-conductrice avec
une couche de base (100, IV) d'un premier type de conductivité;
une première couche (102, III) du premier type de conductivité disposée sur la couche de base (100) et présentant une concentration de dopant qui est inférieure à une concentration de dopant de la couche de base (100, IV); et
une deuxième couche (104, II) d'un deuxième type de conductivité qui coopère avec la première couche (102, III) pour former une transition entre le premier type de conductivité et le deuxième type de conductivité;
**caractérisée par le fait que**
l'évolution (F) d'un profil de dopant à la transition entre la couche de base (100, IV) et la première couche (102, III) partant d'une première concentration de dopant dans la première couche (102, III) est réglée par paliers, en passant par une deuxième concentration de dopant dans la couche de base (100, IV), à une troisième concentration de dopant dans la couche de base (100, IV), la troisième concentration de dopant étant supérieure à la première concentration de dopant et à la deuxième concentration de dopant, et la deuxième concentration de dopant étant supérieure à la première concentration de dopant.

2. Structure semi-conductrice selon la revendication 1, dans laquelle la première concentration de dopant est de 10¹⁶ atomes/cm³, la deuxième concentration de dopant est de 10¹⁷ atomes/cm³ et la troisième concentration de dopant est de 10¹⁹ atomes/cm³.

3. Structure semi-conductrice selon la revendication 1 ou 2, dans laquelle la couche de base est un substrat ou une couche enterrée.

4. Structure semi-conductrice selon la revendication 1 ou 2, dans laquelle la couche de base (100, IV) comprend une couche de substrat et une couche tampon, le profil de dopage (F) s'étendant, partant de 10¹⁶ atomes/cm³ à l'endroit de la première couche (102, III), passant par 10¹⁷ atomes/cm³ à 10¹⁸ atomes/cm³ dans la couche tampon de la couche de base (100, IV), à 10¹⁹ atomes/cm³ à l'endroit de la couche de substrat de la couche de base (100, IV).

5. Structure semi-conductrice selon la revendication 4, dans laquelle un collecteur actif d'un transistor est formé dans la première couche (102, III), et dans laquelle une base et un émetteur du transistor sont formés dans la seconde couche (104, II).

6. Structure semi-conductrice selon la revendication 5, dans laquelle le transistor est un transistor de puissance.

7. Structure semi-conductrice selon la revendication 5 ou 6, dans laquelle le transistor est un transistor bipolaire ou un transistor à effet de champ.

8. Structure semi-conductrice selon la revendication 3, dans laquelle une diode est formée dans la première couche (102, III) et dans la seconde couche (104, II).

9. Procédé pour améliorer la résistance à la décharge électrostatique et la résistance à la surcharge d'une structure semi-conductrice, la structure semi-conductrice comprenant une couche de base (100, IV) d'un premier type de conductivité, une première couche (102, III) du premier type de conductivité disposée sur la couche de base (100, IV) et présentant une concentration de dopant inférieure à une concentration de dopant de la couche de base (100, IV), et une deuxième couche (104, II) d'un deuxième type de conductivité, la première couche (102, III) et la deuxième couche (104, II) coopérant pour former une transition entre le premier type de conductivité et le deuxième type de conductivité,
**caractérisé par** l'étape suivante consistant à:
régler par paliers l'évolution du profil de dopant (B, C, D, E) à la transition entre la couche de base (100, IV) et la première couche (102, III), partant d'une première concentration de dopant dans la première couche (102, III), passant par une deuxième concentration de dopant dans la couche de base (100, IV), à une troisième concentration de dopant dans la couche de base (100, IV), la troisième concentration de dopant étant supérieure à la première concentration de dopant, et la deuxième concentration de dopant étant supérieure à la première concentration de dopant.

10. Procédé selon la revendication 4, dans lequel la première concentration de dopant est de 10¹⁶ atomes/cm³, la deuxième concentration de dopant est de 10¹⁷ atomes/cm³ et la troisième concentration de dopant est de 10¹⁹ atomes/cm³.

11. Procédé selon la revendication 9 ou 10, dans lequel la couche de base est un substrat ou une couche enterrée.

12. Procédé selon la revendication 10 ou 11, dans lequel la couche de base (100, IV) comprend une couche de substrat et une couche tampon, le profil de dopant (F) s'étendant, partant de 10¹⁶ atomes/cm³ à l'endroit de la première couche (102, III), passant par 10¹⁷ atomes/cm³ à 10¹⁸ atomes/cm³ dans la couche tampon dans la couche de base (100, IV), à 10¹⁹ atomes/cm³ à l'endroit de la couche de substrat dans la couche de base (100, IV).

13. Procédé selon la revendication 12, dans lequel une zone de la première couche (102, III) constitue un collecteur actif d'un transistor, et dans lequel une base et un émetteur du transistor sont formés dans la deuxième couche (104, II), la deuxième couche étant déposée sur la première couche ou étant formée dans la première couche par des zones introduites.

14. Procédé selon la revendication 13, dans lequel le transistor est un transistor de puissance.

15. Procédé selon la revendication 13 ou 14, dans lequel le transistor est un transistor bipolaire ou un transistor à effet de champ.

16. Procédé selon la revendication 12, dans lequel une diode est formée dans la première couche (102, III) et dans la deuxième couche (104, II).

17. Procédé selon l'une des revendications 13 à 16, aux étapes suivantes consistant à:
préparer la couche de substrat de la couche de base (100, IV);
générer la couche tampon sur la couche de substrat de la couche de base (100, IV), la couche tampon ne présente pas de dopage ou présente un faible dopage;
générer un profil de dopage à paliers par une implantation locale de dopants sous le transistor à former ou sous la diode à former;
générer la première couche (102, III) sur la couche tampon;
générer la deuxième couche (104, II) par dépôt de la deuxième couche sur la première couche ou par génération de zones actives dans la première couche; et
générer le transistor ou la diode.

18. Procédé selon la revendication 17, dans lequel le dopage de la couche tampon est du premier type de conductivité ou du deuxième type de conductivité, et dans lequel est obtenu, à l'étape de génération du profil de dopage par paliers par l'implantation locale dans la couche tampon, un dopage du premier type de conductivité de l'ordre de 10¹⁷ atomes/cm³ à 10¹⁸ atomes/cm³.

19. Procédé selon la revendication 17 ou 18, dans lequel la génération du transistor comprend la formation de la base et de l'émetteur dans la deuxième couche, la première couche servant de collecteur.
